# EUROPÄISCHE PATENTSCHRIFT

(11) **EP 1 059 835 B1**
(45) Veröffentlichungstag und Bekanntmachung des Hinweises auf die Patenterteilung: **02.01.2004**
(21) Anmeldenummer: 00109581.9
(22) Anmeldetag: 05.05.2000
(51) Int. Cl.: H05K 7/14, G06F 13/40

(54) **Datenübermittlung zwischen Modulen eines elektrischen Geräts**
Data processing between modules of an electrical apparatus
Transmission de données entre modules d' un appareil électrique

(30) Priorität: 11.06.1999 DE 19926849
(43) Veröffentlichungstag der Anmeldung: 13.12.2000
(73) Patentinhaber: Bodenseewerk Gerätetechnik GmbH, 88662 Überlingen (DE)
(72) Erfinder: Reichel, Reinhard, Dr., 78333 Stockach (DE)
(74) Vertreter: Weisse, Jürgen, Dipl.-Phys.

(56) Entgegenhaltungen:
- EP-A- 0 824 302
- DE-A- 3 417 451
- DE-A- 4 132 994
- DE-A- 4 412 310
- US-A- 4 562 535
- US-A- 5 408 616
- US-A- 5 724 343

## Beschreibung

### Technisches Gebiet

Die Erfindung betrifft ein elektronisches Gerät enthaltend: einen Kabinettrahmen, eine Mehrzahl von Modulen unterschiedlicher Funktion mit Modulrahmen, die herausziehbar nebeneinander in dem Kabinettrahmen gehaltert sind, Leiterplatten, welche in den Modulrahmen gehaltert sind und elektronische Bauteile tragen, und Datenübertragungsmittel zur Herstellung der Kommunikation zwischen jedem der Module und wenigstens einem anderen dieser Module.

### Stand der Technik

In der Avionik werden verschiedene Avionikfunktionen in autonomen Einheiten untergebracht. Bei Auftreten eines Fehlers wird die gesamte Einheit ausgetauscht. Diese Einheit besteht häufig aus einem Gehäuse, in dem die einzelnen Avionikfunktion untergebracht sind. Die Tendenz in der Avionik geht jedoch hier, wie auch in vielen anderen technischen Bereichen, dahin, modulare Systeme zu verwenden. Dies hat den Vorteil, daß bei Ausfall einer Avionikfunktion nicht die gesamte Einheit ausgetauscht werden muß, sondern nur das einzelne, ausgefallene Modul. Die Module sind in der Regel Leiterplatinen mit elektrischen Bauteilen. Diese Module sind an einem Modul-Rahmen angeordnet, der in einen Kabinett-Rahmen eingeschoben werden kann.

Zwischen den einzelnen Modulen in dem Kabinett-Rahmen muß Information ausgetauscht werden. Die entsprechenden Kommunikationsverbindungen verlaufen als Datenbus in der Rückwand des Kabinett-Rahmens. Über entsprechende Steckverbindungen zum Datenbus werden die Module beim Einschub in den Kabinett-Rahmen miteinander verbunden.

Das Prinzip von Datenbussen ist bekannt. Unter einem klassischen "Multi-Transmitter- /Multi-Receiver"-Datenbus ist eine Sammelleitung zur Datenübertragung zwischen mehreren Funktionseinheiten zu verstehen. Bei einer solchen Busstruktur benötigt man grundsätzlich nur eine Übertragungsleitung, an die alle Geräte angeschlossen sind und über die die Kommunikation aller Geräte abgewickelt wird. Allerdings erfordert der einfache Aufbau des Kommunikationsweges eine aufwendigere Verwaltung. Da prinzipiell alle angeschlossenen Geräte Nachrichten senden und empfangen können, muß dafür gesorgt werden, daß nicht gleichzeitig verschiedene Geräte Daten senden und nur solche Geräte auf Empfang geschaltet sind, für die die momentan gesendeten Daten bestimmt sind. Die Verwaltung des Busses wird häufig durch einen eigenen Buskontroller übernommen.

Die ARINC-Norm "ARINC 659" beschreibt einen sogenannten "Backplane Bus". Der "Backplane Bus" ist ein Bussystem, das in der Rückwand eines Einschub-Kabinetts angeordnet ist. In dieser Norm ist das Bussystem als sogenannter "Multiplex-Bus" ausgestaltet.

Aus dem deutschen Patent DE 41 32 994 C2 ist ein Einschub-System in Modulbauweise mit Leiterplatten, die elektrische Bauteile tragen, bekannt.

Die veröffentlichte europäische Patentanmeldung EP 0 824 302 A1 beschreibt ein elektronisches Gerät in Modulbauweise mit Leiterplatten, die elektrische Bauteile tragen. Die Leiterplatten sind in einem Modul-Rahmen in Einschubmodulen angeordnet. Die Einschub-Module sind ihrerseits in einem Kabinett-Rahmen herausziehbar gehaltert. Dabei sind die Einschubmodule mit einer Rückwand-Baugruppe elektrisch verbunden.

In der DE-OS 34 17 451 wird ein quaderförmiges Einschubsystem für elektronische Geräte beschrieben, in das Steckkarten-Moduleinschübe und dergleichen eingeschoben werden können.

Die US-Patentschrift 5,724,343 zeigt eine Anordnung, bei welcher die Datenübertragung über ein Bus-System und ein für alle Module gemeinsamen "Coupling Module" erfolgt, durch welches die mit Label versehenen Daten auf die verschiedenen Module verteilt werden.

Die DE 44 12 310 A1 betrifft die Verarbeitung der Daten mehrerer, redundant vorgesehener Sensoren durch mehrere, ebenfalls redundant vorgesehene Rechner, derart, daß ein oder mehrere Fehler an den Sensoren und den Rechnern erkannt und eliminiert werden können. Hier kommt es auf die Gleichzeitigkeit der Verarbeitungen der verschiedenen Daten an. Es gilt ja, die in den verschiedenen Kanälen jeweils zu einem bestimmten Zeitpunkt auftretenden Daten miteinander zu vergleichen, um fehlerhafte Daten zu eliminieren. Hier muß man daher die Daten unmittelbar zwischen den verschiedenen Rechnen übertragen.

Die bekannte Modulkommunikation von Einschub-Kabinetten hat den Nachteil, daß eine Einschränkung der Sicherheit bei der Datenübertragung von einem Modul zum nächsten durch Datenkollision nicht ausgeschlossen werden kann. Die Vermeidung von Kollisionen erfordert eine aufwendige Organisation des Datenflusses. Gleichzeitig wird damit aber auch die Fehleranfälligkeit des Datenflusses erhöht, da die Kommunikationsprozesse zwischen den einzelnen Modulen nicht unabhängig verlaufen.

Nachteilig hat sich bei elektrischen Geräten nach dem Stand der Technik erwiesen, daß bei herkömmlichen Busstrukturen nicht einfach zu erkennen ist, wann die Kommunikation eines Moduls nicht mehr funktioniert.

### Offenbarung der Erfindung

Aufgabe der Erfindung ist es daher ein elektronisches Gerät in Modulbauweise zu schaffen, bei dem die Nachteile des Standes der Technik beseitigt werden. Weiterhin soll die Kommunikation innerhalb des elektronischen Gerätes über Kollisionsfreiheit, zeitliche Determiniertheit und Unabhängigkeit von sonstigen Geräte- bzw. modulinternen Funktionen bei der Datenübermittlung verfügen.

Erfindungsgemäß wird die Aufgabe dadurch gelöst, daß
(a) die Datenübertagungsmittel in jedem Modul autonome Datensendemittel, autonome Datenempfangsmittel sowie einen Datenübertragungskontroller aufweisen und
(b) jedem Modul für die Datenübertragung zu einem anderen Modul eine gesonderte, mit den Datensendemitteln verbundene Datenleitung zugeordnet ist, wobei jede dieser Datenleitungen das betreffende Modul direkt mit den Datenempfangsmitteln des anderen Moduls verbindet.

Durch die direkte Übertragung der Daten von einem Modul zum nächsten erreicht man Kollisionsfreiheit bei der Datenübertragung. Die Steuerung der Kommunikation zwischen den Modulen ist unabhängig von den Prozessoreinheiten der Module. Bei Verwendung der direkten Kommunikation der Module untereinander ist es erheblich einfacher als beim Stand der Technik, weitere Module untereinander in ein bereits kommunizierenden Modulverbund hinzuzunehmen. Die Kommunikation bereits kommunizierender Module wird nämlich durch hinzukommende Module nicht gestört.

Weitere Ausgestaltungen der Erfindung sind Gegenstand der abhängigen Ansprüche.

### Kurze Beschreibung der Zeichnung

- Fig. 1: zeigt eine Prinzipskizze eines Kabinett-Rahmens mit einem Multiplex-Datenbus und herausnehmbare Module nach dem Stand der Technik.
- Fig. 2: zeigt eine Prinzipskizze eines erfindungsgemäßen elektrischen Geräts mit direkter Modulkommunikation.
- Fig.2a: zeigt eine Prinzipskizze der erfindungsgemäßen direkten Modulkommunikation mit einer Sendeeinrichtung und mehreren Empfangseinrichtungen.
- Fig.2b: zeigt eine Prinzipskizze der erfindungsgemäßen direkten Modulkommunikation mit jeweils zu jeder Sendeeinrichtung eine zugehörige Empfangseinrichtungen.
- Fig.2c: zeigt eine Prinzipskizze der erfindungsgemäßen direkten Modulkommunikation in einer Kombination von Fig.2a und Fig.2b.
- Fig.3: zeigt als Prinzipskizze den Modulaufbau in dem Bereich, der für die direkte Modulkommunikation relevant ist.
- Fig.4: zeigt das Prinzip des zeitgesteuerten Übertragungsprotokolls

### Detaillierte Beschreibung der Zeichnungen

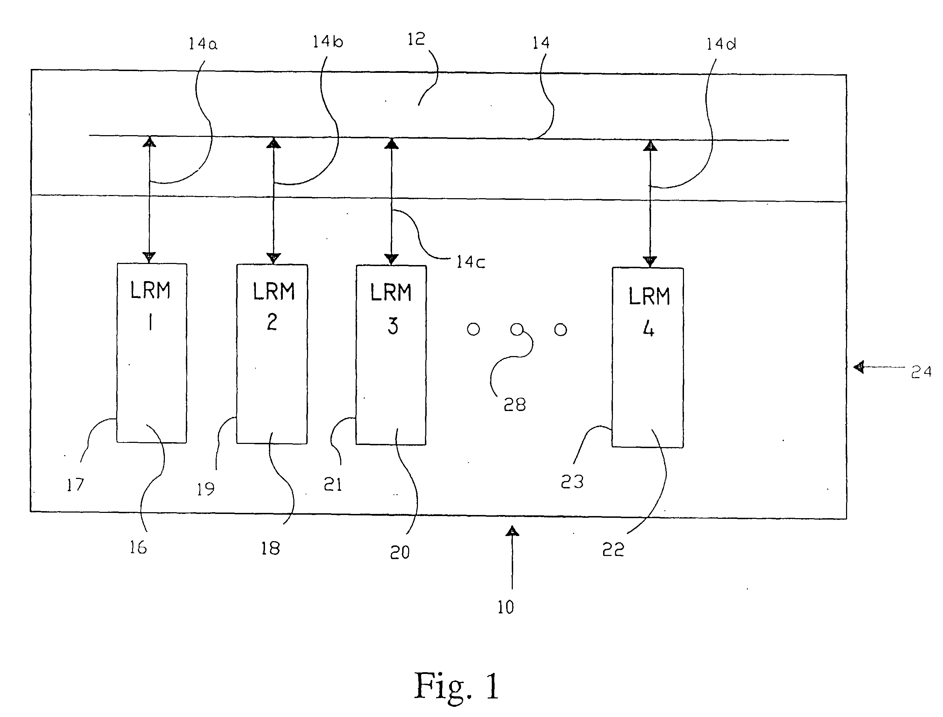

Um vorliegende Erfindung vorteilhafter beschreiben zu können, wird anhand von Fig. 1 dargestellt, wie ein elektrisches Gerät mit den Merkmalen des Oberbegriffs arbeitet.

In Fig. 1 ist mit 10 ein Kabinett-Rahmen bezeichnet. Der Kabinett-Rahmen 10 weist in seiner Rückwand 12 einen einfachen Multiplex-Datenbus 14 auf. Dieser besteht einfachstenfalls aus einem einfachen Kabel. In dem Kabinett-Rahmen 10 werden austauschbare elektrische Module 16, 18, 20, 22 eingesteckt. Die Module 16, 18, 20, 22 weisen dazu einen Modulrahmen 17, 19, 21, 23 auf, der in den Kabinett-Rahmen 10 eingeschoben werden kann, bis sie Kontakt mit einer Spannungsversorgung und dem Multiplex-Datenbus 14 erhalten. Die Anzahl der Module 16, 18, 20, 22 ist abhängig von der Aufnahmefähigkeit des Kabinetts. Über den Multiplex-Datenbus 14 sind die einzelnen Module 16, 18, 20, 22 miteinander verbunden. Dies wird mit Pfeilen 14a, 14b, 14c, 14d angedeutet. Der Datenfluß zwischen den Modulen 16, 18, 20, 22 des Kabinett-Rahmens 10 wird entweder durch einen Buskontroller gesteuert oder durch ein entsprechendes Übertragungsprotokoll jedes einzelnen Moduls, im sogenannten Multiplexbetrieb, geregelt. Als Ganzes bildet der Kabinett-Rahmen 10 mit den Modulen 16, 18, 20, 22 und Datenbus 14 ein funktionales elektrisches Gerät 24.

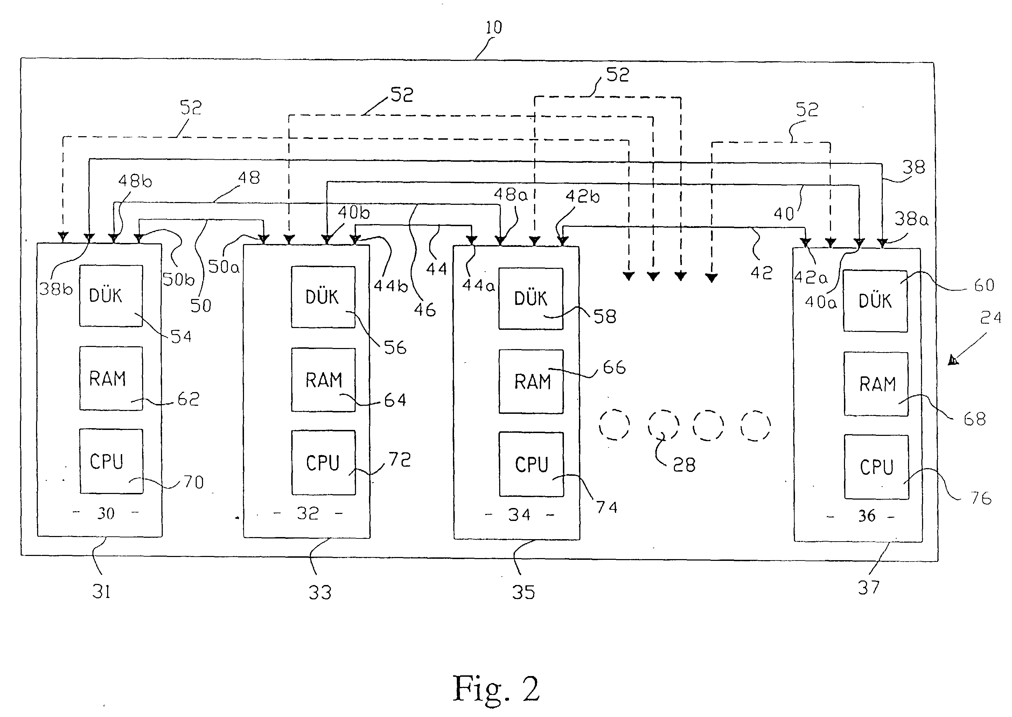

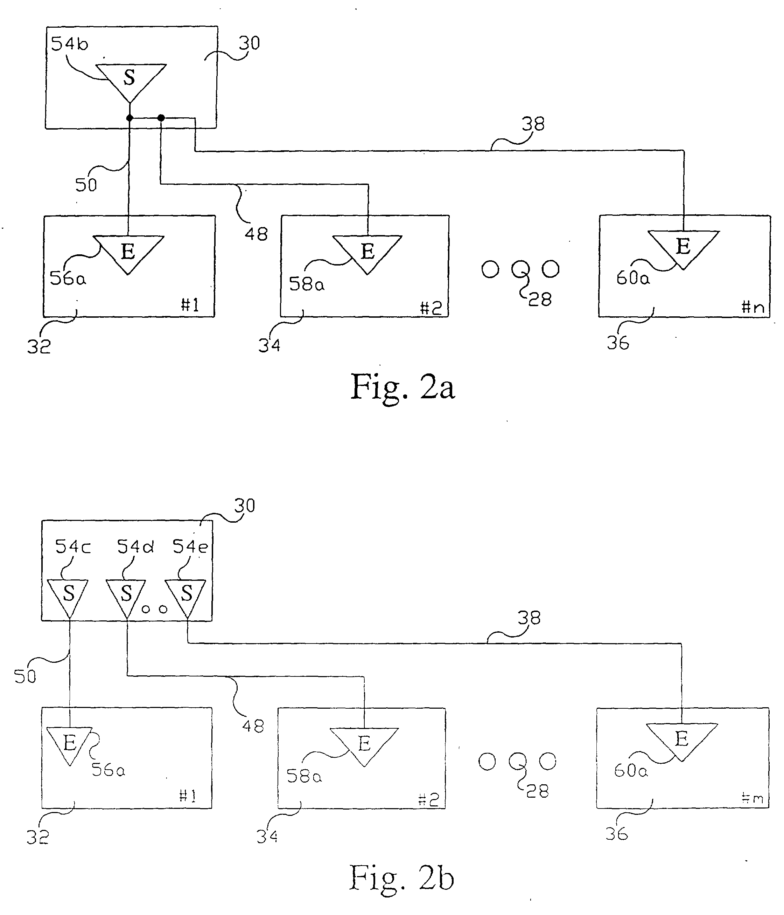

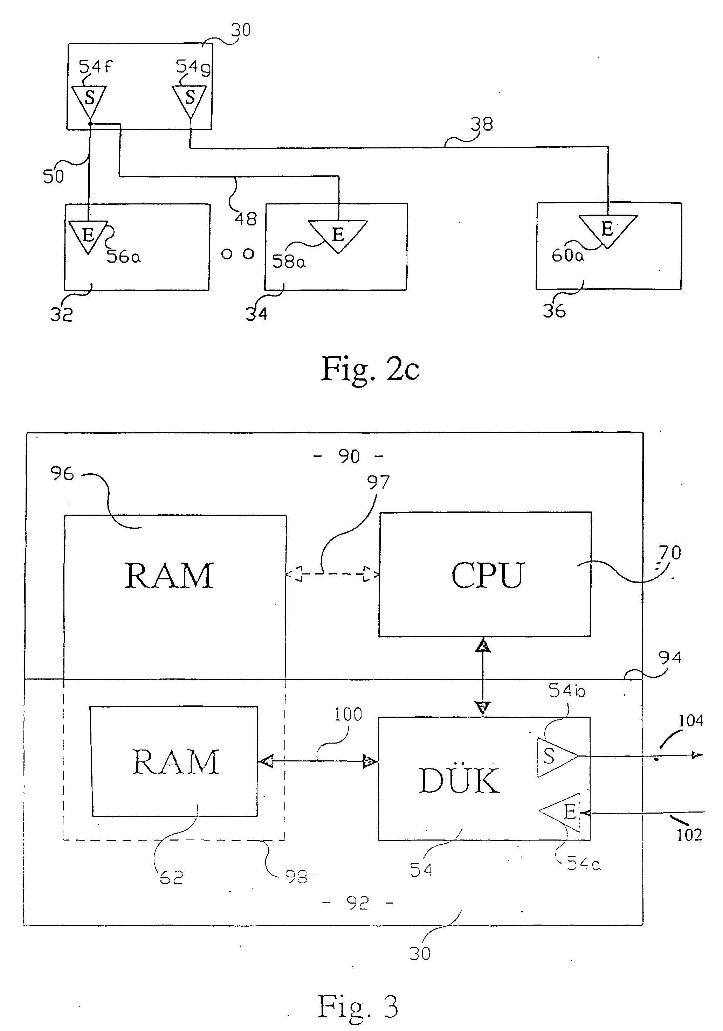

In Fig. 2 wird ein elektrisches Gerät 24, ähnlich wie in Fig. 1, gezeigt. Bei diesem elektrischen Gerät 24 wird jedoch kein Datenbus verwendet. In den Kabinett-Rahmen 10 werden die austauschbaren elektrischen Module 30, 32, 34, 36 eingesteckt. Die Module 30, 32, 34, 36 weisen dazu einen Modulrahmen 31, 33, 35, 37 auf, der in den Kabinett-Rahmen 10 eingeschoben werden kann, bis sie insbesondere Kontakt mit einer Spannungsversorgung erhalten. Die Punkte 28 deuten an, daß beliebig viele ― nicht dargestellte - Module verwendet werden können. Die Anzahl der Module 30, 32, 34, 36 ist abhängig von der Aufnahmefähigkeit des Kabinett-Rahmens 10. Erfindungsgemäß wird hier jedes Modul 30, 32, 34, 36 direkt mit den anderen Modulen 30, 32, 34, 36 über direkte Verbindungen 38, 40, 42, 44, 46, 48, 50 miteinander verbunden.

Pfeile 38a, 40a, 42a, 44a, 46a, 48a, 50a, 38b, 40b, 42b, 44b, 46b, 48b, 50b deuten an, daß der Datenfluß durch die direkten Verbindungen in zwei Richtungen verlaufen kann. Dies wird im vorliegenden Ausführungsbeispiel durch jeweils separate unidirektionale Verbindungen gelöst. Für jede Richtung des Datenflusses und jeden Empfänger wird wenigstens eine eigene Datenleitung verwendet. Es sollte aber auch bei Bedarf eine unidirektionale Verbindung möglich sein, d.h., daß der Datenfluß nur in eine Richtung über eine separate Verbindung verläuft. Die Verbindungen für Datenübertragungen können sowohl seriell als auch parallel ausgestaltet sein.

Gestrichelte Linien 52 stehen für weitere direkte Verbindungen mit aus Gründen der Übersichtlichkeit nicht dargestellten Modulen. Jedes der Module 30, 32, 34, 36 weist einen eigenen Datenübertragungs-Kontroller (DÜK) 54, 56, 58, 60 auf. Die Datenübertragungs-Kontroller (DÜK) 54, 56, 58, 60 verfügen über spezielle Bauelemente bzw. bei integrierten Schaltungen um spezielle Bestandteile zur Datenübermittlung. Weiterhin ist in jedem der Module 30, 32, 34, 36 ein Datenspeicher (RAM) 62, 64, 66, 68 sowie eine Prozessoreinheit (CPU) 70, 72, 74 und 76 vorgesehen. Die Datenübertragungs-Kontroller (DÜK) 54, 56, 58, 60 regeln die Kommunikation mit den jeweils anderen Modulen. Als Ganzes bildet der Kabinett-Rahmen 10 mit den Modulen 30, 32, 34 und 36 ein funktionales elektrisches Gerät 24.

Mit den Figuren 2a bis 2c sollen verschiedene Möglichkeiten der direkten Kommunikation zwischen Modulen eines erfindungsgemäßen Geräts 24 verdeutlicht werden. Die herausnehmbaren Module 30, 32, 34 und 36 sind in den Figuren 2a bis 2c als Blöcke dargestellt. Die Punkte 28 deuten an, daß beliebig viele Module verwendet werden können. Die Anzahl der Module ist wiederum nur von der Aufnahmekapazität des Kabinett-Rahmens abhängig. Anhand von den Ausführungsbeispielen der Figuren 2a bis 2c soll die Weitergabe von einem ersten Modul 30 an andere Module 32, 34, 36 dargestellt werden.

In dem Ausführungsbeispiel von Fig.2a ist nur eine Sendeeinrichtung 54b des ersten Moduls 30 dargestellt. Die Sendeeinrichtung 54b kann als integraler Bestandteil des Datenübertragungs-Kontrollers oder als separates Bauteil ausgebildet sein. Durch Teilen der Verbindung werden die gesendeten Daten des ersten Moduls 30 auf direktem Weg über die Verbindungen 38, 48 und 50 an Empfänger 56a, 58a und 60a der anderen Module 32, 34, 36 geschickt. Die Empfangseinrichtungen 56a, 58a und 60a sind ebenfalls entweder Bestandteil des Datenübertragungskontrollers oder als separates Bauteil ausgebildet.

In dem Ausführungsbeispiel von Fig.2b ist für jede direkte Verbindung 38, 48, 50 eine eigene Sendeeinrichtung 54c, 54d, 54e des ersten Moduls 30 dargestellt. Die Sendeeinrichtungen 54c, 54d, 54e können als integrale Bestandteile des Datenübertragungs-Kontrollers oder als separate Bauteile ausgebildet sein. Ein Teilen der Verbindungsleitung ist bei diesem Ausführungsbeispiel von Fig. 2b nicht erforderlich, weil für jede Empfangseinrichtung eine Sendeeinrichtung vorgesehen ist. Die zu sendenden Daten des ersten Moduls 30 werden auf direktem Weg über die Verbindungen 38, 48 und 50 an Empfänger 56b, 58b und 60b der anderen Module 32, 34, 36 geschickt, wo sie schließlich in einem Datenspeicher zu Weiterverarbeitung abgelegt werden. Die Empfangseinrichtungen 56a, 58a und 60a sind entweder Bestandteil des Datenübertragungs-Kontrollers 54 oder als separates Bauteil ausgebildet.

Ausführungsbeispiel von Fig.2c kombiniert die beiden direkten Verbindungsarten von Fig. 2a und 2b. In Fig. 2c ist sowohl eine Sendeeinrichtung 54f mit und eine Sendeeinrichtung 54g ohne Teilung der Verbindungsleitung vorgesehen. Die Sendeeinrichtungen 54f und 54g können als integrale Bestandteile des Datenübertragungs-Kontrollers 54 oder als separate Bauteile ausgebildet sein. Die gesendeten Daten des ersten Moduls 30 werden auf direktem Weg über die Verbindungen 38, 48 und 50 an Empfänger 56b, 58b und 60b der anderen Module 32, 34, 36 geschickt, wo sie schließlich in einem Datenspeicher zu Weiterverarbeitung abgelegt werden. Die Empfangseinrichtungen 56a, 58a und 60a sind entweder Bestandteil des Datenübertragungs-Kontrollers oder als separates Bauteil ausgebildet.

Die Arten der direkten Datenübermittlung, wie sie in den Figuren 2a bis 2c dargestellt werden, verhindern, daß Datenströme in irgendeiner Weise kollidieren können, da sie immer auf direktem Weg vom Sender zum Empfänger gelangen.

In Fig. 3 wird der prinzipielle Modulaufbau eines Moduls 30 gezeigt, wie er erforderlich ist, um eine direkte Kommunikation mit anderen Modulen zu ermöglichen. Das Modul 30 enthält eine Funktionseinheit 90, die die eigentliche Modulfunktion übernimmt und eine Datenübertragungseinheit 92 zur Übertragung von Daten. Die Funktionseinheit 90 ist durch eine Linie 94 in dieser Darstellung von der Datenübertragungseinheit 92 getrennt. Die Funktionseinheit enthält eine Prozessoreinheit (CPU) 70 und einen Speicher 96. Die Prozessoreinheit 70 ist mit dem Speicher 96 verbunden. Pfeil 97 deutet den Zugriff auf den Speicher 96 an. Der Datenspeicher 62 zur Datenübermittlung kann ein von der Funktionseinheit 90 losgelöster Datenspeicher, aber auch in den Speicher 96 der Funktionseinheit 90 als Speicherbereich, wie in diesem Ausführungsbeispiel, eingebunden sein. Der Speicher 96 der Funktionseinheit 90 greift als gestrichelter Teilblock 98 daher auch in die Datenübermittlungseinheit 92 über.

Der Datenübertragungs-Kontroller 54 ist mit diesem Datenspeicher 62 verbunden. Der Datenaustausch wird mit Pfeil 100 symbolisiert. Zu versendende Daten werden nun entweder direkt durch die Prozessoreinheit 70 oder indirekt über den Datenübertragungs-Kontroller 54 in den Datenspeicher 62 abgelegt, je nachdem, ob die Prozessoreinheit direkten Zugriff auf den Datenspeicher 62 hat oder nicht. Weiterhin enthält der Datenübertragungs-Kontroller 54 eine Empfangs- 54a und eine Sendeeinrichtung 54b. Über die Empfangs- 54a und eine Sendeeinrichtung 54b werden entsprechende Daten von anderen Modulen empfangen bzw. zu anderen Modulen versendet. Pfeile 102 und 104 deuten den Empfang bzw. das Versenden an. Je nach Bedarf kann eine serielle oder auch parallele Datenübertragung zwischen den einzelnen Modulen verwendet werden. Alle Datenübertragungsfunktionen und deren Elemente sind, soweit wie möglich, von der übrigen Modulfunktion des jeweiligen Moduls separiert.

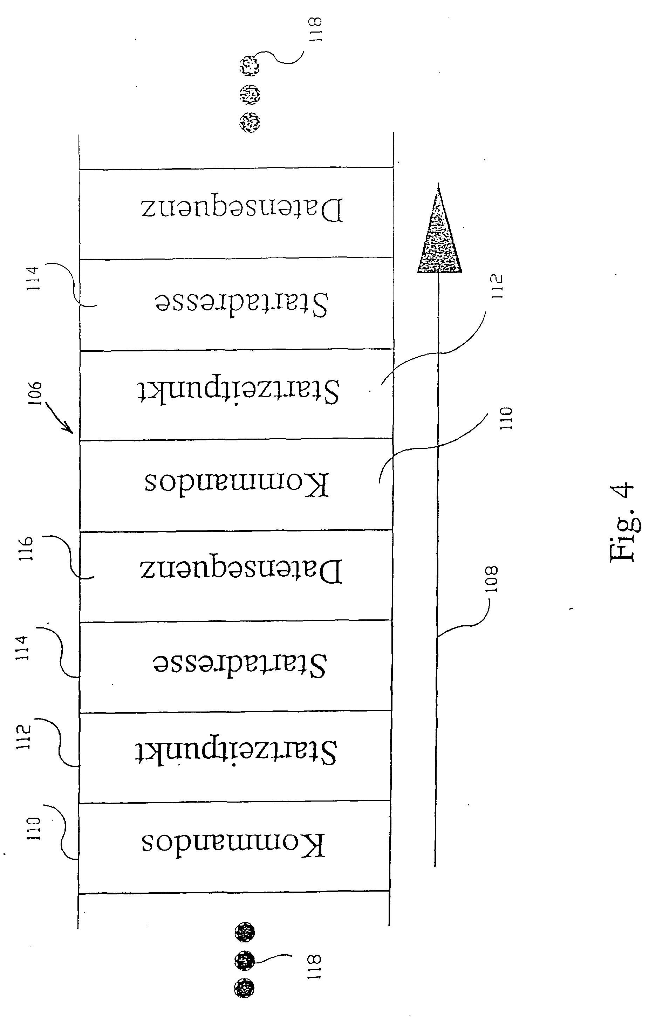

In Fig. 4 wird das Prinzip eines für die direkte Kommunikation erforderliches Übertragungsprotokoll dargestellt. Hierbei handelt es sich um ein zeitgesteuertes und nicht interruptgesteuertes Übertragungsprotokoll. Das Übertragungsprotokoll ist als eine Steuersequenz 106, wie sie im Datenübertragungs-Kontroller 54 abgearbeitet wird, gezeigt. Diese Steuersequenz 106 wird in Pfeilrichtung 108 abgearbeitet. Sie besteht im Prinzip aus vier Steuerblöcken: Ein erster Block 110 enthält Kommandos für Ablaufsteuerung der Datenübermittlung. Ein zweiter Block 112 enthält den Startzeitpunkt, wann Daten gesendet werden sollen. Ein dritter Block 114 enthält die jeweilige Startadresse im Datenspeicher 62 der zu übertragenden Datensequenz und Block 116 beinhaltet die Größe der zu übertragenden Datensequenz. Die Steuersequenz 106 besteht häufig aus vielen aneinandergereihten Steuersequenzen. Dies wird durch Punkte 118 symbolisiert.

## Patentansprüche

1. Elektronisches Gerät (24) enthaltend: einen Kabinettrahmen (10), eine Mehrzahl von Modulen (30,32,34,36) unterschiedlicher Funktion mit Modulrahmen (31,33,35,37), die herausziehbar nebeneinander in dem Kabinettrahmen (10) gehaltert sind, Leiterplatten, welche in den Modulrahmen (31,33,35,37) gehaltert sind und elektronische Bauteile tragen, und Datenübertragungsmittel zur Herstellung der Kommunikation zwischen jedem der Module (30,32,34,36) und wenigstens einem anderen dieser Module, **dadurch gekennzeichnet, daß**
(a) die Datenübertagungsmittel in jedem Modul (30,32,34,36) autonome Datensendemittel (54b,56b,58b,60b), autonome Datenempfangsmittel (54a,56a,58a,60a) sowie einen Datenübertragungskontroller (54,56,58,60) aufweisen und
(b) jedem Modul (30,32,34,36) für die Datenübertragung zu einem anderen Modul eine gesonderte, mit den Datensendemitteln (54b,56b,58b,60b) verbundene Datenleitung (38,40,42,44,46,48,50) zugeordnet ist, wobei jede dieser Datenleitungen (38,40,42,44,46,48,50) das betreffende Modul direkt mit den Datenempfangsmitteln (54a,56a,58a,60a) des anderen Moduls verbindet.

2. Elektronisches Gerät nach Anspruch 1, **dadurch gekennzeichnet, daß** die Datenübertragungsmittel mit einem zeitgesteuerten Kommunikationsprotokoll zur Datenübermittlung vorgesehen sind.

3. Elektronisches Gerät nach Anspruch 1 oder 2, **dadurch gekennzeichnet, daß** in jedem Modul (30,32,34,36) ein Datenspeicher (62,64,66,68) zum Speichern zu übermittelnder Daten für die Versendung oder zum Speichern empfangener Daten für die Weiterverarbeitung vorgesehen ist, der mit den Datenübertragungsmittel verbunden ist.

4. Elektronisches Gerät nach einem der Ansprüche 1 bis 3, **gekennzeichnet durch** Verteilermittel zum gleichzeitigen Versenden von Daten von einem Modul (30) zu mehreren anderen Modulen (32,34,36).

## Claims

1. Electronic device (24) comprising: a cabinet frame (10), a plurality of modules (30,32,34,36) of different functions with module frames (31,33,35,37) which are removably retained side-by-side in the cabinet frame (10), printed circuit boards, which are mounted in the module frames (31,33,35,37) and carry electronic components, and data transmitting means for establishing communication between each of the modules (30,32,34,36) and at least another one of these modules, **characterised in that**
(a) the data transfer means comprise autonomous data transmission means (54b,56b,58b,60b), autonomous data receiving means (54a,56a,58a,60a) as well as a data transmission controller (54,56,58,60) in each module (30,32,34,36), and
(b) a separate data line (38,40,42,44,46,48,50) connected to the data transmission means (54b,56b,58b,60b) is associated with each module (30,32,34,36) for the data transmitting to another module, each of these data lines (38,40,42,44,46,48,50) connecting the respective module directly with the data receiving means (54a,56a,58a,60a) of the other module.

2. Electronic device as claimed in claim 1, wherein said data transfer means are provided with a time-controlled communication protocol for transmitting data.

3. Electronic device as claimed in claim 1 or 2, **characterised in that**, in each module (30,32,34,36), a data memory (62,64,66,68) for storing the data to be transmitted for transmission or for storing received data for further processing, this memory being connected to the data transmission means.

4. A device as claimed in one of the claims 1 to 3, **characterised in that** each module comprises distributor means for simultaneously transmitting data from one module (30) to a plurality of other modules (32,34,36).

## Revendications

1. Appareil électronique (24) comprenant : un cadre de boîtier (10), plusieurs modules (30,32,34,36) de fonction différente munis de cadres de module (31,33,25,37) maintenus dans le cadre de boîtier (10) les uns à côté des autres de façon à pouvoir être retirés, des circuits imprimés maintenus dans les cadres de module (31,33,25,37) et portant des composants électroniques, et des moyens de transmission de données destinés à établir la communication entre chacun des modules (30,32,34,36) et au moins à un autre de ces modules,
**caractérisé en ce que**
(a) les moyens de transmission de données présentent dans chaque module (30,32,34,36) des moyens d'émission de données autonomes (54b,56b,58b,60b), des moyens de réception de données autonomes (54a,56a,58a,60a) ainsi qu'un contrôleur de transmission de données (54,56,58,60) et
(b) une conduite de données séparée (38,40,42,44,46,48,50) reliée aux moyens d'émission de données (54b,56b,58b,60b) est associée à chaque module (30,32,34,36) pour la transmission de données vers un autre module, chacune de ces conduites de données (38,40,42,44,46,48,50) reliant le module correspondant directement aux moyens de réception de données (54a,56a,58a,60a) de l'autre module.

2. Appareil électronique selon la revendication 1, **caractérisé en ce que** les moyens de transmission de données sont pourvus d'un protocole de communication synchrone destiné à la diffusion des données.

3. Appareil électronique selon la revendication 1 ou 2, **caractérisé en ce qu'**une mémoire de données (62,64,66,68) reliée aux moyens de transmission de données et destinée à mémoriser les données devant être diffusées en vue de leur envoi ou destinée à mémoriser les données reçues en vue de leur traitement est prévue dans chaque module (30,32,34,36).

4. Appareil électronique selon l'une quelconque des revendications 1 à 3, **caractérisé par** des moyens de répartition destinés à envoyer simultanément des données d'un module (30) vers plusieurs autres modules (32,34,36).
